# EUROPEAN PATENT SPECIFICATION

(11) **EP 3 529 875 B1**
(45) Date of publication and mention of the grant of the patent: **10.06.2020**
(21) Application number: 17793681.2
(22) Date of filing: 18.10.2017
(51) Int. Cl.: H02J 7/00, G01R 31/36, H02J 7/04

(54) **CHARGING CONTROL**
LADESTEUERUNG
DISPOSITIF DE COMMANDE DE CHARGE

(30) Priority: 19.10.2016 WO PCT/FI2016/050733
(43) Date of publication of application: 28.08.2019
(73) Proprietor: BrightCharger Europe Oy Ltd, 40950 Muurame (FI)
(72) Inventor: TIAINEN, Harri, 40950 Muurame (FI)
(74) Representative: Papula Oy
(86) International application number: PCT/FI2017/050726
(87) International publication number: WO 2018/073494

(56) References cited:
- US-A- 5 175 485
- US-A- 5 237 259
- US-A- 5 396 163
- US-A1- 2013 342 173

## Description

### BACKGROUND

Many portable electrical devices have a battery that requires charging, and the charging operation has become a daily routine to people. People often keep their electrical devices such as smart phones, lap-tops, tablets, electric toothbrushes, shavers or for example drills charging overnight or almost all the time. They also may simply forget to unplug their chargers. Excessive charging of battery powered devices wastes energy, reduces battery lifetime and increases the risk of fire.

From the user's perspective, it requires effort to repeatedly monitor the filling or the charge percentage of the battery of the chargeable device, due to which the device may be charged for a considerably longer time than required to charge the battery nearly full. However, device batteries can only be charged for a limited amount of time before they may become damaged or worn. Keeping chargers plugged in when they are not needed consumes unnecessary energy, wears down batteries and causes overheating of both batteries and the chargers themselves, which increases the risk of fire.

In general, devices to be charged are able to switch from using charging current to the use of standby current when the battery of a chargeable device becomes full. Although standby current is considerably lower than charging current, on an annual level it still leads to significant electricity consumption. The charger also consumes current when left connected to the mains current, even if the charger was not connected to a chargeable device. This electricity consumption is completely useless and wasted energy. Scaling the problem up to a global level, electricity may be wasted by chargers to an extent that may equal the production of several nuclear power plants. Furthermore, the standby current supplied by chargers to a chargeable device destroys or weakens the capacity of the battery of the chargeable device, speeding up the decrease of capacity of the battery. The batteries may have a certain life span of the available overall charging. Prior art charging control devices are disclosed in US5237259 A and US5175485 A.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter. The present invention is defined by the independent apparatus claim 1, corresponding independent method claim 15 and and computer program apparatus claim 16. Preferred embodiments are defined by the dependent claims.

It is an object to provide a charging control device. The object is achieved by the features of the independent claims. Some embodiments are described in the dependent claims. In an embodiment a device comprises: a detector configured to detect a charging current of a battery of an electrical device and to determine charging current values in relation to the charging current; a switch configured to connect and disconnect the charging; a controller configured to detect a maximum value of the charging current values; after detecting the maximum value, the controller is further configured to detect a threshold current value of the charging current values; after detecting the threshold current value, the controller is configured to detect a change of subsequent values of the charging current values, and based on the change to detect whether the change exceeds a threshold change value; after detecting the exceeding of the threshold change value, the controller is further configured to control the switch for disconnecting the charging.

Other embodiments relate to a method and a computer program for controlling a charger device.

### BRIEF DESCRIPTION OF THE DRAWINGS

The accompanying drawings, which are included to provide a further understanding of the invention and constitute a part of this specification, illustrate embodiments of the invention and together with the description help to explain the principles of the invention. In the drawings:
FIG. 1 illustrates a schematic diagram of a charging current of a charging operation according to an embodiment;
FIG. 2 illustrates a schematic flow chart of a charging operation based on a charging current according to an embodiment;
FIG. 3 illustrates a schematic flow chart of a charging operation based on a charging current according to another embodiment;
FIG. 4 illustrates a schematic block diagram of a device according to an embodiment;
FIG. 5 illustrates a schematic representation of a row of seats with integrated charging ports of a device according to an embodiment;
FIG. 6 illustrates a schematic representation of a general structure with integrated charging ports of the device according to an embodiment;
FIG. 7 illustrates a schematic representation of a seat with integrated charging ports of a device according to an embodiment;
FIG. 8 illustrates a schematic block diagram of integration of a charging control device into a structure with a single charging panel according to an embodiment;
FIG. 9 illustrates a schematic block diagram of integration of a charging control device into a structure with multiple charging panels according to an embodiment; and
FIG. 10 illustrates a schematic representation of integration of a charging control device into a charger according to an embodiment.

### DETAILED DESCRIPTION

The detailed description provided below in connection with the appended drawings is intended as a description of the present embodiments and is not intended to represent the only forms in which the present embodiment may be constructed or utilized. However, the same or equivalent functions and sequences may be accomplished by different embodiments.

Although the present embodiments may be described and illustrated herein as being implemented in a smartphone or a mobile phone and a respective charger, these are only examples of an electrical device having a battery to be charged by a charger, and not a limitation. As those skilled in the art will appreciate, the present embodiments are suitable for application in a variety of different types of battery operated devices that require charging, for example in tablets, phablets, computers, cameras, game consoles, laptop computers, domestic electrical devices, tools, drills, electrical toothbrushes, vacuum cleaners with a battery, etc.

A device configured to perform the charging operations as described in the below embodiments may be one or more circuits, such as asic or logic implemented chip, software, such as a computer program. It may be embodied in a charger. It could be embedded into a typical charger, or designed as a design charger. The device may be integrated or embedded into a structural element or into a construction, for example, it may be in a chair or in a seat of a vehicle or an airplane, inside to wall, having an output to the chargeable device, etc.

According to an embodiment, the device detects a charging current of a battery of an electrical device. At first, the device detects a maximum, or a peak value of the charging current. The maximum value illustrates the maximum charging current the charger may output to the battery during the charging operation. The device may detect unrealistic peak values that would not be the indented maximum values such as peak current values at the start of the charging process. The maximum value may act as a reference value for the charging process. It increases reliability of the determination process. The maximum value is required as a reference point to the second stage of the process, for example acting as a starting reference point to the reference value of the second stage. A certain fixed value acting as the maximum value would not work reliably. Additionally the maximum value may be applied for other charging processes. After detecting the maximum value, the device may detect that the charging current is below a certain threshold, for example half of the maximum, so that the final detection is not unintentionally started too early. The second stage, the detection of the threshold, is performed so that the third stage, the turning the charging off, is not being performed too early. Furthermore, it safeguards that the battery becomes charged fully enough and the charging operation does not send at too early stage. Next, the device detects when the decrease of the charging current has slowed down so that the change of the charging current curve is gentle, for example a 5% difference between sequential charging current values. The third stage detects that the battery has been charged enough, for example being substantially full. The first and the second stages ensure that charging does not stop unnecessary early, for example so that battery is not charged to a substantially full capacity. Otherwise, when the first and the second stages have been considered, the gentle charging curve may be a positive indication that the battery is substantially full or has reasonable amount of charge, and ending the charging operation is feasible. After that the device switches the charging off and ends the charging operation. According to an embodiment, after switching off the charging operation, the device shuts down itself. The device may consequently shut down the whole charger. The battery will have been charged to a substantially full charge within the charging operation and period. The charging has terminated after the charging operation and period has ended. Energy consumed by the charger for charging and/or standby may be saved. The lifetime of the battery may be prolonged because charging is ended and there is no pumping short additional charging cycles. Thus, the battery may be charged to a substantially full state, and charging switched off to save energy and the battery itself. The charging may start anew, for example only by the user's initiation or request, etc.

According to an embodiment the charger may be kept plugged in when it is not needed, and it does not consume unnecessary energy. For example, even when the charger is integrated into a wall. The charging operation does not wear down batteries. Furthermore, the charging operation does not cause overheating of both batteries and the chargers themselves, which could increase the risk of fire. Because the device automatically cuts off the electric current after a specified time depending on the charging current curve, there is no more worrying about forgetting to unplug mobile or other battery powered electronic devices or chargers, for example for the night. The electrical device, such as a mobile device, does not receive charging, and the device automatically stops drawing power from the outlet.

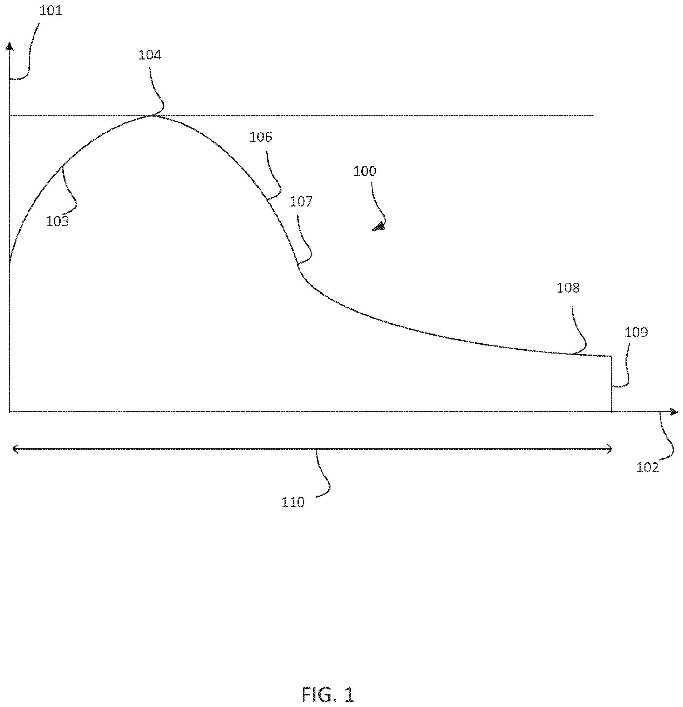

FIG. 1 illustrates a schematic diagram of a charging current 100 of a charging operation according to an embodiment. The charging operation is illustrated in FIG. 1 as having a charging cycle 110. The charging cycle may depend on a battery capacity and/or how much capacity currently the battery has. The charger charges an electrical device according to the charging operation.

The Y axis 101 illustrates a charging current 101 and the X axis 102 illustrates time 102. A detector of the device detects the charging current 100 of a battery of an electrical device. The detector also determines charging current values in relation to the charging current 100.

The detector detects charging current values illustrating the charging current 100 in FIG. 1 based on filtering measurements of the actual charging current within a certain amount of time, for example one second. The detector stores the charging current values per each second. Furthermore, the detector averages the stored charging current values per one minute. The averaged charging current value establishes the charging current value. It should be noted that the numerical values may be altered to more or less frequent, for example the charging current values may be detected hundred times per second, and an average for this may be determined per 10 seconds, etc. Also the current values may be received by a different kind of detection. Consequently, the detected actual charging current correspondences to the charging current value by a reasonable accuracy. There may be some minor exceptions; for example, when the charging current value is zero, the actual charging current may not be exactly zero.

Referring to FIG. 1, when the charging operation has been started the charging current 100 increases at point 103. A controller of the device detects a maximum value 104 of the charging current 100. The controller may detect the maximum value 104 so that a new maximum current value is saved each time the detected maximum value is higher than the previously stored maximum value. After detecting the maximum value 104, the controller may proceed to the next stage of charging, wherein the charging current decreases at point 106. The controller detects a threshold current value 107 at this stage of the charging operation. According to an embodiment, the threshold current value 107 may be between 25% to 75% of the maximum value 104, for example 30% - 70%, 40% - 60%, 45% - 66%, etc. According to an embodiment, the threshold current value 107 is 50% of the maximum current value 104. The controller may proceed to detecting the threshold current value 107 from detecting the maximum value 104 if: a minute average of the detected charging current 100 is smaller than the maximum value 104, and at least a predetermined time, such as at least one minute, has been passed from detecting the latest maximum value 104. According to an embodiment, however, if the controller detects that the maximum value 104 is below a general threshold value, which may depend on the battery capacity and/or the charging state, such as 100mA, within a period of time, such as 120s, the controller may directly control a switch of the device for disconnecting the charging. Consequently, this may relate to the situation where the charging has not started for some reason.

After detecting the threshold current value 107, the controller may proceed to the next state of charging, wherein the decrease of the charging current 100 becomes gentle. Thus, after detecting the threshold current value 107, the controller detects a change of subsequent values of the charging current values. Based on the change, the controller detects whether the change exceeds a threshold change value 108. The controller may detect the change so that at least two subsequent charging current values are detected. The controller then compares the two subsequent charging current values to each other. The change exceeds the threshold change value 108 if the latest value of the subsequent values is certain amount, for example 5%, smaller than the previous value of the subsequent values. Furthermore generally, the controller may check that it has performed this detection for a predetermine time, for example 180s.

After detecting that the threshold change value 108 has been exceeded, the controller controls the switch of the device for disconnecting the charging at point 109. According to an embodiment, the controller controls the switch for disconnecting the charging so that the charging current is switched off from a low voltage end between the device and the battery. According to an embodiment, the controller controls the switch for disconnecting the charging so that the charging current is switched off from a high voltage end between mains electricity and the device. According to an embodiment, after controlling the switch for disconnecting the charging, the controller may further shut down the device, for example after a predetermine time, for example 10s, has lapsed. Consequently, the device may shut down the whole charger or charging apparatus. According to an embodiment, after controlling the switch for disconnecting the charging, the controller may further switch illumination of the device on.

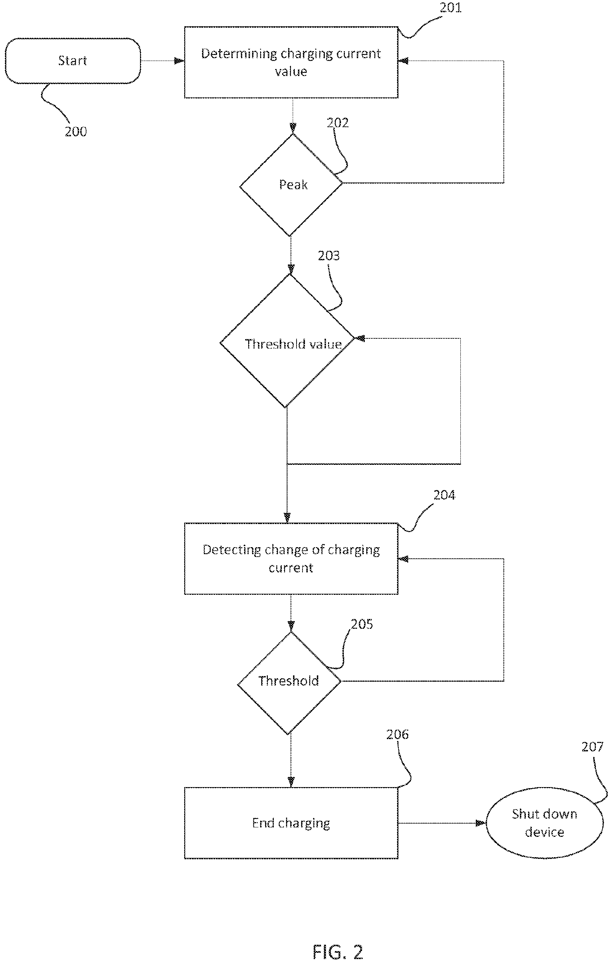

FIG. 2 illustrates a schematic flow chart of the charging operation according to an embodiment. The flow chart is performed in the device as the charging operation.

In operation 200, the charging operation starts. For example, the user initiates charging by connecting the charger and the electronic device, or makes an indication to start charging. In operation 201, a charging current 100 of a battery of an electrical device is detected. The charging current values are determined in relation to the charging current. In operation 202, a maximum value 104 of the charging current 100 is determined. In case the maximum value is not determined, the process returns to operation 201. In case the maximum value 104 is detected, the process proceeds to operation 203. In operation 203, the charging current is detected and a threshold current value of the charging current is detected. In case it is not detected, the process remains at operation 203. After detecting the threshold current value, the process proceeds to operation 204 for detecting a change of charging current. In operation 205, if the change of the charging current exceeds a threshold, the process proceeds to operation 206, and if it does not exceed, the process remains at operation 205. After detecting that the charging current exceeds the threshold, the process proceeds to operation 206 for disconnecting the charging. The device may be switched off at operation 207.

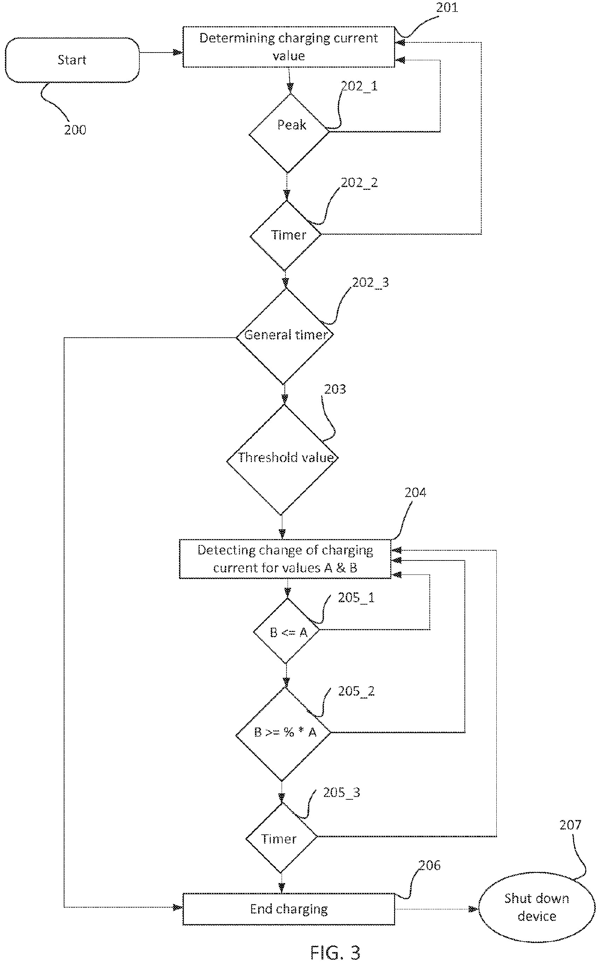

FIG. 3 illustrates a schematic flow chart of the charging operation according to another embodiment. The charging process of FIG. 3 may be similar to the embodiment of FIG. 2 with respect to operations 200, 201, 203, 204, 206 and 207. FIG. 3 illustrates an embodiment for operation 200 of FIG. 2. It should be noted that the numerical values, which are described in the embodiments, are only illustrative, and there may be other numerical values as well. For example, the numerical values may be in relation to a capacity of the battery to be charged. Consequently, they may vary greatly, depending to the battery capacity and used charging current. Additionally the charging determination may be based on different kind of numerical values, wherein the relation of the used numerical values varies greatly than the embodiments described.

In operation 202_1, the maximum value 104 is detected so that a current charging current value is compared to the stored maximum value 104. In case the current value is smaller than the stored maximum value, the process proceeds to operation 202_2. In operation 202_2, a timer is checked so that a certain time, for example one minute, has lapsed after the detection of the maximum value. In operation 202_3, a general timer is checked so that if the charging current value is below a threshold, for example 100mA, and a certain time, for example 120 seconds, has lapsed, the process proceeds directly to operation 206 ending the charging. This may relate to the situation where the charging has not started for some reason. In case both operations 202_1 and 202_2 are fulfilled, the process proceeds to operation 203.

In operation 204, two charging current values A and B are determined. They are subsequent and/or consequtive. For example, charging current value A may be determined for T - 120 seconds and T - 61 seconds, and B for T - 60 seconds and T. From the embodiment of FIG. 2, operation 205 is illustrated in FIG. 3 as operations 205_1, 205_2 and 205_3. In operation 205_1, it is checked whether B is smaller than A. In operation 205_2, it is further checked that B is certain amount bigger than A, for example B >= 0,95 ^{∗} A. In operation 205_3, it is checked that at least a certain amount of time has been used for operations 205_1 and 205_2, for example at least 3 minutes has lapsed.

According to an embodiment, in operation 204, three or more charging current values may be determined. They may be subsequent and/or consecutive charging current values, which are determined according to the embodied process. However, the second value or the value(s) in the middle, for example values between the first and the last ones of the embodied operation 204, may be omitted. Consequently, the determination of the operation 205, for example operation 205_1, 205_2, 205_3 may be based on the first and the last ones of these values only.

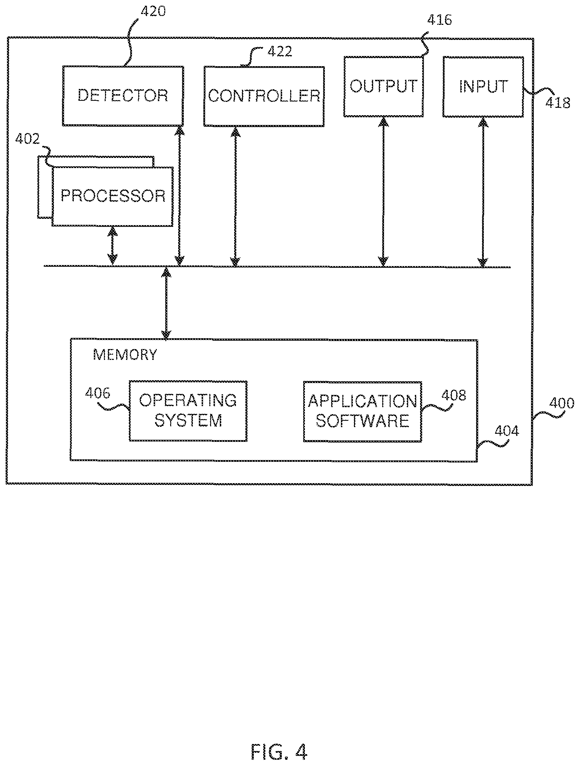

FIG. 4 illustrates an embodiment of components of a device 400 which may be implemented in a form of a computing and/or programmable logic for the charging operation. The device 400 is configured to perform the operations and functions of FIGs 1 to 3 as described above.

The device 400 comprises one or more processors 402 which may be microprocessors, controllers or any other suitable type of processors for processing computer executable instructions to control the operation of the device 400. Platform software comprising an operating system 406 or any other suitable platform software may be provided on the chargers to enable application software 408 to be executed on the device.

Computer executable instructions may be provided using any computer-readable media that are accessible by the device 400. Computer-readable media may include, for example, computer storage media such as a memory 404 and communications media. Computer storage media, such as a memory 404, include volatile and nonvolatile, removable and non-removable media implemented in any method or technology for storage of information such as computer readable instructions, data structures, or program modules. Computer storage media include, but are not limited to, RAM, ROM, EPROM, EEPROM, flash memory or other memory technology, optical storage, magnetic disk storage or other magnetic storage devices, or any other non-transmission medium that can be used to store information for access by a computing device. In contrast, communication media may embody computer readable instructions, data structures, program modules, in a modulated data signal, such as a carrier wave, or other transport mechanism. The device 400 may comprise an input 418 which may be a reception. Alternatively, the device 400 may be coupled to an input acting as a reception, which is not a part of the device 400. According to an embodiment, it may be an AC input of 230V. The reception may be configured to receive electric current and accordingly electrical power energy from electric mains. The device 400 comprises a detector 420. The detector 420 is configured to detect charging of the battery. The detector 420 detects values for the charging such as the charging current. The device 400 may comprise an output 416 such as a supply. Alternatively, the device 400 may be coupled to an output acting as a supply, which is not a part of the device 400. The supply is configured to supply the charging current to the battery. According to an embodiment, it may be a USB connector.

The device 400 comprises a controller 422. The controller 422 is configured to control the charging based on the detected value of the charging. The controller 422 receives input signals from the detector 420. The controller outputs signals for switching off the charging.

According to an embodiment the controller 422 may operate in combination with the processor 402, and the software 408 may be configured for the charging operations and functions as discussed above with respect to the embodiments of FIGs 1 to 3.

The functionality described herein can be performed, at least in part, by one or more hardware logic components. According to an embodiment, the device 400 is configured by the program code 406,408, when executed by the processor 402, to execute the embodiments of the operations and functionality described. Alternatively, or in addition, the functionality described herein can be performed, at least in part, by one or more hardware logic components. For example, and without limitation, illustrative types of hardware logic components that can be used include Field-programmable Gate Arrays (FPGAs), Program-specific Integrated Circuits (ASICs), Program-specific Standard Products (ASSPs), System-on-a-chip systems (SOCs), Complex Programmable Logic Devices (CPLDs), Graphics Processing Units (GPUs).

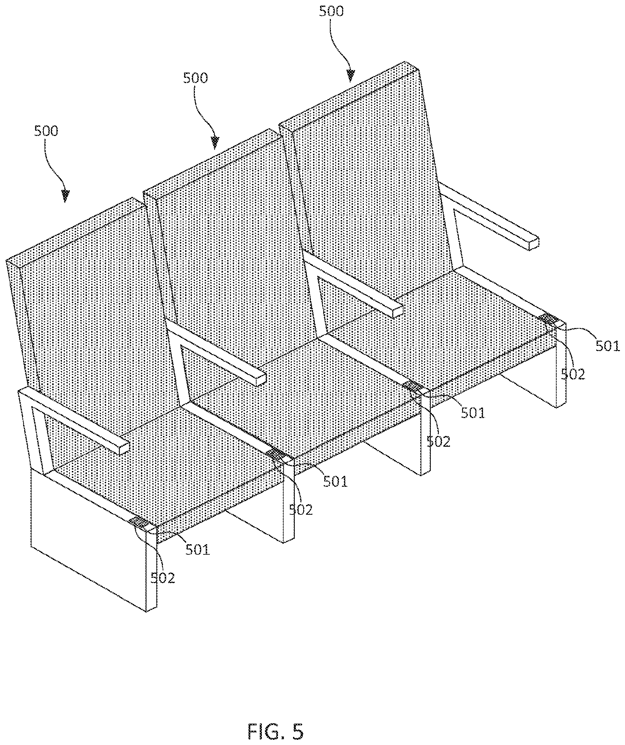

FIGs 5 - 10 illustrate schematic representations of various embodiments of the device 400, for example in so called integrated "wallboxes" type of structures. Each wallbox comprises a charging panel 501, wherein the panel 501 may comprise one or multiple charging ports 502, which may be, for example, USB ports for charging mobile devices. Furthermore, wallboxes may comprise the device 400 in order to implement the charging operation described in the embodiments.

FIG. 5 illustrates a row of seats 500 comprising multiple charging panels 501 according to an embodiment. Such rows of seats 500 may be installed to, for example, airports or any other public or private place, allowing passengers the user, or general public to charge their mobile devices using the charging ports 502. Furthermore one or more row of seats 500 may in installed in a vehicle, such as an airplane or a bus. The device 400 can be integrated into each seat 500 or ports 501 of multiple seats 500 can be operated by a single device 400.

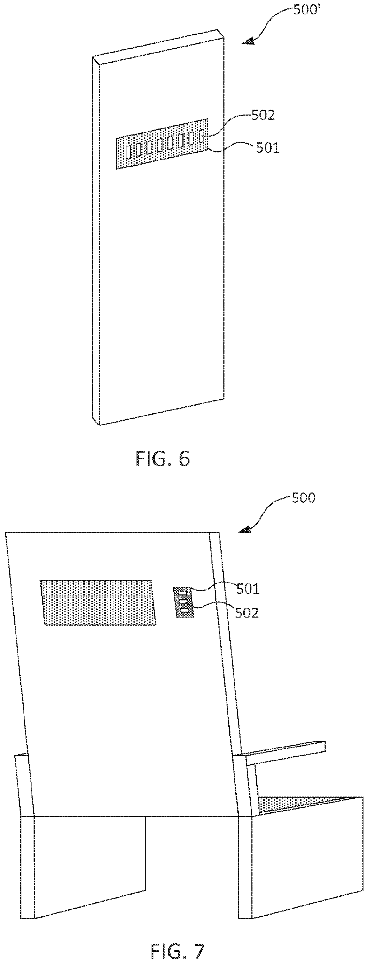

FIG. 6 illustrates a schematic representation of a general structure 500' comprising an integrated charging panel 501 according to an embodiment. The general structure 500' may be, for example, a wall of a building or it may be a separate standalone structure which can be moved. The charging panel 501 comprises multiple charging ports 502. The device 400 can be integrated into the structure 500'.

FIG. 7 illustrates a schematic representation of a seat 500 with an integrated charging panel 501 according to an embodiment. The seat 500 may be, for example, a seat on an airplane, in a card or in a building. The charging panel 501 comprises multiple charging ports 502, and the panel 501 may be positioned, for example, on the backside of the seat 500 so that a passenger positioned in a seat behind the seat 500 may use the charging ports 502. This way the panel 501 is positioned conveniently for the rear passenger, and the panel 501 can be integrated in a similar fashion with other multimedia equipment that are usually positioned on the backside of the seat 500. The device 400 may be integrated into the seat 500 or it may be positioned outside the seat 500, in which case a single device 400 can be used for multiple seats 500.

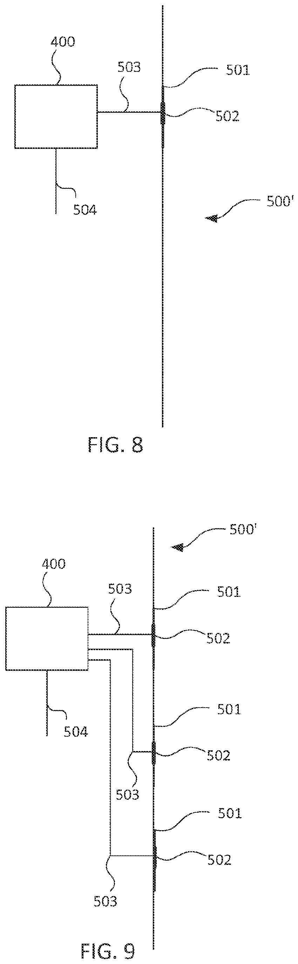

FIGs. 8 and 9 illustrate schematic representations of integration of wallboxes to general structures 500' according to an embodiment. In FIG. 8, single charging panel 501 is attached to a surface of the structure 500', and the panel 501 comprises one or more charging ports 502 as described above. The device 400 is connected to the panel 501 and to the ports 502 using wires 503. The wires 503 provide power to the ports 502 from the device 400, and on the other hand, permit the device 400 to monitor the output current of the ports 502 in order to implement the charging operation described in the embodiments. Additionally, the device 400 is connected to external power using the wires 504. FIG. 9 illustrates a similar structure to FIG. 8. However, multiple panels 501 are attached to a surface of the structure 500'. Again, one panel may comprise one or more charging ports 502. Each of the panels 501 and ports 502 is connected to the device 400 through wires 503. Thus, a single device 400 can power and monitor multiple panels 501 and implement the charging operation to all ports simultaneously and/or individually. For example, the device 400 can operate a single port 502 individually. The operation may be performed as described in various embodiments. In the embodiments of FIG. 8 and 9, the device 400 may be situated in the vicinity of the panel 501 or the device 400 may be situated far away from the panel 501.

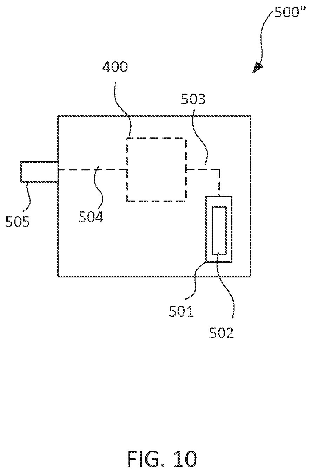

FIG. 10 illustrates a schematic representation of integration of the device 400 into a charger 500". The charger 500" comprises a charging panel 501, and the panel comprises a single charging port 502, which can be used to charge various devices, such as mobile phones. The number of ports 502 may also be higher. The charger 500'' further comprises the device 400 and a connector 505, which can be used to connect the charger 500'' to, for example, a 110 volt, V, or 230 V power outlet. Power is provided from the connector 505 to the device 400 through wires 504. The device 400, in turn, provides power to the port 502 through the wires 503, monitors the charging current in the port 502 and implements the charging operation described earlier in the embodiments.

The methods and functionalities described herein may be performed by software in machine readable form on a tangible storage medium e.g. in the form of a computer program comprising computer program code means adapted to perform all the functions and the steps of any of the methods described herein when the program is run on a computer and where the computer program may be embodied on a computer readable medium. Examples of tangible storage media include computer storage devices comprising computer-readable media such as disks, thumb drives, memory etc. and do not include propagated signals. The software can be suitable for execution on a parallel processor or a serial processor such that the method steps may be carried out in any suitable order, or simultaneously.

This acknowledges that software can be a valuable, separately tradable commodity. It is intended to encompass software, which runs on or controls "dumb" or standard hardware, to carry out the desired functions. It is also intended to encompass software which "describes" or defines the configuration of hardware, such as HDL (hardware description language) software, as is used for designing silicon chips, or for configuring universal programmable chips, to carry out desired functions.

Those skilled in the art will realize that storage devices utilized to store program instructions can be distributed across a network. For example, a remote computer may store, parts or all of, an example of the process described as software. A local or terminal computer may access the remote computer and download a part or all of the software to run the program. Alternatively, the local computer may download pieces of the software as needed, or execute some software instructions at the local terminal and some at the remote computer (or computer network). Alternatively, or in addition, the functionality described herein can be performed, at least in part, by one or more hardware logic components. For example, and without limitation, illustrative types of hardware logic components that can be used include Field-programmable Gate Arrays (FPGAs), Application-specific Integrated Circuits (ASICs), Application-specific Standard Products (ASSPs), System-on-a-chip systems (SOCs), Complex Programmable Logic Devices (CPLDs), etc.

Any range or device value given herein may be extended or altered without losing the effect sought. Also any embodiment may be combined with another embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item refers to one or more of those items.

The steps of the methods described herein may be carried out in any suitable order, or simultaneously where appropriate. Additionally, individual blocks may be deleted from any of the methods without departing from the spirit and scope of the subject matter described herein. Aspects of any of the examples described above may be combined with aspects of any of the other examples described to form further examples without losing the effect sought.

The term 'comprising' is used herein to mean including the method, blocks or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments without departing from the scope of this specification. The scope of the invention being defined by the appended claims.

## Claims

1. A device(400), comprising:
a detector (420) configured to detect a charging current of a battery of an electrical device and to determine charging current values of the charging current;
a switch configured to connect and disconnect charging;
a controller (422) configured to detect a maximum value of the charging current values;
after detecting the maximum value, the controller is further configured to detect a threshold current value of the charging current values in relation to the detected maximum value;
after detecting the threshold current value, the controller is configured to detect a change of subsequent values of the charging current values, and based on the change to detect whether the change exceeds a threshold change value, wherein the change exceeds the threshold change value if a latest value of the subsequent values is a certain amount smaller than a previous value of the subsequent values;
after detecting the exceeding of the threshold change value, the controller is further configured to control the switch for disconnecting charging.

2. The device of claim 1, wherein the controller is configured to detect the maximum value of the charging current values so that a new value is saved each time a maximum value which is higher than the previous value is detected; the controller is configured to proceed to detecting the threshold current value if:
a minute average of the detected charging current value is smaller than the maximum value; and
a predetermined time has passed from detecting the latest maximum value.

3. The device of any preceding claim, wherein if the controller detects that the maximum value is below a general threshold value within a period of time, the controller is configured to directly control the switch for disconnecting charging.

4. The device of any preceding claim, wherein the threshold current value of the charging current values in relation to the detected maximum value is between 25% to 75% of the detected maximum value.

5. The device of claim 4, wherein the threshold current value of the charging current values in relation to the detected maximum value is 50% of the detected maximum value.

6. The device of any preceding claim, wherein the controller is configured to detect the change so that two subsequent charging current values are detected, and the two subsequent charging current values are compared to each other; and
wherein the change exceeds the threshold change value if the latest value of the two subsequent charging current values is certain amount smaller than the previous value of the two subsequent charging current values; and the controller has performed detection for a predetermined time.

7. The device of any preceding claims 1-5, wherein the controller is configured to detect the change so that three subsequent charging current values are detected, the centremost value of the three subsequent charging current values is deleted and the outermost values of the three subsequent charging current values are compared to each other; and
wherein the change exceeds the threshold change value if a difference between the outermost values exceed a certain amount; and the controller has performed detection for a predetermined time.

8. The device of any preceding claim, wherein the controller is configured to control the switch for disconnecting charging so that the charging current is switched off from a low voltage end between the device and the battery.

9. The device of any preceding claim, wherein the controller is configured to control the switch for disconnecting charging so that the charging current is switched off from a high voltage end between mains electricity and the device.

10. The device of claims 8 or 9, wherein after controlling the switch for disconnecting charging, the controller is further configured to shut down the device after a predetermined time has lapsed.

11. The device of any preceding claim, wherein after controlling the switch for disconnecting charging, the controller is further configured to switch illumination of the device on.

12. The device of claim 1, wherein the detector is configured to detect the charging current value based on
filtering measurements of the charging current taking place within one second;
storing charging current values per each second; averaging the stored charging current values per one minute, wherein the averaged charging current value establishes said charging current value.

13. A charger (500"), comprising the device (400) according to any preceding claim, configured to charge the battery of the electrical device.

14. A structure (500'), comprising the device (400) according to any preceding claim 1-12, configured to charge the battery of the electrical device.

15. A method, comprising:
detecting a charging current of a battery of an electrical device;
determining charging current values of the charging current;
detecting a maximum value of the charging current values in relation to the detected maximum value;
after detecting the maximum value, detecting a threshold current value of the charging current values;
after detecting the threshold current value, detecting a change of subsequent values of the charging current values, and
based on the change detecting whether the change exceeds a threshold change value, wherein the change exceeds the threshold change value if a latest value of the subsequent values is certain amount smaller than a previous value of the subsequent values;
after detecting the exceeding of the threshold change value, controlling the switch for disconnecting charging.

16. A computer program, comprising a program code configured to perform the steps of the method of claim 15 when executed by a computer.

## Patentansprüche

1. Vorrichtung (400), die umfasst.
einen Detektor (420), der dazu ausgelegt ist, einen Aufladestrom einer Batterie einer elektrischen Vorrichtung zu detektieren und Aufladestromwerte des Aufladestroms zu bestimmen;
einen Schalter, der dazu ausgelegt ist, das Aufladen zu verbinden und zu trennen;
eine Steuereinheit (422), die dazu ausgelegt ist, einen Maximalwert der Aufladestromwerte zu detektieren;
wobei nach dem Detektieren des Maximalwerts, die Steuereinheit ferner dazu ausgelegt ist, einen Schwellenstromwert der Aufladestromwerte in Bezug auf den detektierten Maximalwert zu detektieren;
wobei nach dem Detektieren des Schwellenstromwerts die Steuereinheit dazu ausgelegt ist, eine Änderung von folgenden Werten der Aufladestromwerte zu detektieren, und auf der Basis der Änderung zu detektieren, ob die Änderung einen Schwellenänderungswert überschreitet, wobei die Änderung den Schwellenänderungswert überschreitet, wenn ein letzter Wert der folgenden Werte um einem bestimmten Betrag kleiner ist als ein vorheriger Wert der folgenden Werte;
wobei nach dem Detektieren des Überschreitens des Schwellenänderungswerts die Steuereinheit ferner dazu ausgelegt ist, den Schalter zum Trennen des Aufladens zu steuern.

2. Vorrichtung nach Anspruch 1, wobei die Steuereinheit dazu ausgelegt ist, den Maximalwert der Aufladestromwerte zu detektieren, so dass ein neuer Wert jedes Mal gespeichert wird, wenn ein Maximalwert, der höher ist als der vorherige Wert, detektiert wird;
die Steuereinheit dazu ausgelegt ist, zum Detektieren des Schwellenstromwerts überzugehen, wenn:
ein Mittelwert einer Minute des detektierten Aufladestromwerts kleiner ist als der Maximalwert; und
eine vorbestimmte Zeit ab dem Detektieren des letzten Maximalwerts vergangen ist.

3. Vorrichtung nach einem vorangehenden Anspruch, wobei, wenn die Steuereinheit detektiert, dass der Maximalwert unter einem allgemeinen Schwellenwert innerhalb einer Zeitdauer liegt, die Steuereinheit dazu ausgelegt ist, den Schalter zum Trennen des Aufladens direkt zu steuern.

4. Vorrichtung nach einem vorangehenden Anspruch, wobei der Schwellenstromwert der Aufladestromwerte in Bezug auf den detektierten Maximalwert zwischen 25 % und 75 % des detektierten Maximalwerts liegt.

5. Vorrichtung nach Anspruch 4, wobei der Schwellenstromwert der Aufladestromwerte in Bezug auf den detektierten Maximalwert 50 % des detektierten Maximalwerts ist.

6. Vorrichtung nach einem vorangehenden Anspruch, wobei die Steuereinheit dazu ausgelegt ist, die Änderung so zu detektieren, dass zwei folgende Aufladestromwerte detektiert werden und die zwei folgenden Aufladestromwerte miteinander verglichen werden; und
wobei die Änderung den Schwellenänderungswert überschreitet, wenn der letzte Wert der zwei folgenden Aufladestromwerte um einen bestimmten Betrag kleiner ist als der vorherige Wert der zwei folgenden Aufladestromwerte; und die Steuereinheit die Detektion für eine vorbestimmte Zeit durchgeführt hat.

7. Vorrichtung nach beliebigen vorangehenden Ansprüchen 1-5, wobei die Steuereinheit dazu ausgelegt ist, die Änderung so zu detektieren, dass drei folgende Aufladestromwerte detektiert werden, wobei der ganz mittlere Wert der drei folgenden Aufladestromwerte gelöscht wird und die äußersten Werte der drei folgenden Aufladestromwerte miteinander verglichen werden; und
wobei die Änderung den Schwellenänderungswert überschreitet, wenn eine Differenz zwischen den äußersten Werten einen bestimmten Betrag überschreitet; und die Steuereinheit die Detektion für eine vorbestimmte Zeit durchgeführt hat.

8. Vorrichtung nach einem vorangehenden Anspruch, wobei die Steuereinheit dazu ausgelegt ist, den Schalter zum Trennen des Aufladens so zu steuern, dass der Aufladestrom von einem Niederspannungsende zwischen der Vorrichtung und der Batterie ausgeschaltet wird.

9. Vorrichtung nach einem vorangehenden Anspruch, wobei die Steuereinheit dazu ausgelegt ist, den Schalter zum Trennen des Aufladens so zu steuern, dass der Aufladestrom von einem Hochspannungsende zwischen der Netzelektrizität und der Vorrichtung ausgeschaltet wird.

10. Vorrichtung nach den Ansprüchen 8 oder 9, wobei nach dem Steuern des Schalters zum Trennen des Aufladens die Steuereinheit ferner dazu ausgelegt ist, die Vorrichtung abzuschalten, nachdem eine vorbestimmte Zeit abgelaufen ist.

11. Vorrichtung nach einem vorangehenden Anspruch, wobei nach dem Steuern des Schalters zum Trennen des Aufladens die Steuereinheit ferner dazu ausgelegt ist, die Beleuchtung der Vorrichtung einzuschalten.

12. Vorrichtung nach Anspruch 1, wobei der Detektor dazu ausgelegt ist, den Aufladestromwert zu detektieren auf der Basis des
Filterns von Messungen des Aufladestroms, die innerhalb einer Sekunde stattfinden;
Speicherns von Aufladestromwerten pro jede Sekunde;
Mittelns der gespeicherten Aufladestromwerte pro eine Minute, wobei der gemittelte Aufladestromwert den Aufladestromwert festlegt.

13. Ladegerät (500") mit der Vorrichtung (400) nach einem vorangehenden Anspruch, das dazu ausgelegt ist, die Batterie der elektrischen Vorrichtung aufzuladen.

14. Struktur (500') mit der Vorrichtung (400) nach einem vorangehenden Anspruch 1-12, die dazu ausgelegt ist, die Batterie der elektrischen Vorrichtung aufzuladen.

15. Verfahren, das umfasst:
Detektieren eines Aufladestroms einer Batterie einer elektrischen Vorrichtung;
Bestimmen von Aufladestromwerten des Aufladestroms;
Detektieren eines Maximalwerts der Aufladestromwerte in Bezug auf den detektierten Maximalwert;
nach dem Detektieren des Maximalwerts Detektieren eines Schwellenstromwerts der Aufladestromwerte;
nach dem Detektieren des Schwellenstromwerts Detektieren einer Änderung von folgenden Werten der Aufladestromwerte und
auf der Basis der Änderung Detektieren, ob die Änderung einen Schwellenänderungswert überschreitet, wobei die Änderung den Schwellenänderungswert überschreitet, wenn ein letzter Wert der folgenden Werte um einen bestimmten Betrag kleiner ist als ein vorheriger Wert der folgenden Werte;
nach dem Detektieren des Überschreitens des Schwellenänderungswerts Steuern des Schalters zum Trennen des Aufladens.

16. Computerprogramm mit einem Programmcode, der dazu ausgelegt ist, die Schritte des Verfahrens nach Anspruch 15 durchzuführen, wenn er durch einen Computer ausgeführt wird.

## Revendications

1. Dispositif (400), comprenant:
un détecteur (420) configuré pour détecter un courant de charge d'une batterie d'un appareil électrique et pour déterminer des valeurs de courant de charge du courant de charge;
un commutateur configuré pour connecter et déconnecter une charge;
une commande (422) configurée pour détecter une valeur maximale des valeurs de courant de charge;
après une détection de la valeur maximale, la commande est en outre configurée pour détecter une valeur seuil de courant des valeurs de courant de charge en relation avec la valeur maximale détectée;
après une détection de la valeur seuil de courant, la commande est configurée pour détecter une variation des valeurs subséquentes des valeurs de courant de charge, et sur la base de la variation pour détecter si la variation dépasse une valeur seuil de variation; dans lequel la variation dépasse la valeur seuil de variation si une dernière valeur des valeurs subséquentes est une certaine quantité plus petite qu'une valeur précédente des valeurs subséquentes;
après une détection du dépassement de la valeur seuil de variation, la commande est en outre configurée pour commander le commutateur pour déconnecter une charge.

2. Dispositif selon la revendication 1, dans lequel la commande est configurée pour détecter la valeur maximale des valeurs de courant de charge de sorte qu'une nouvelle valeur est enregistrée à chaque fois qu'une valeur maximale qui est supérieure à la valeur précédente est détectée;
la commande est configurée pour procéder à une détection de la valeur seuil de courant si:
une moyenne par minute de la valeur de courant de charge détectée est inférieure à la valeur maximale; et
un temps prédéterminé s'est écoulé depuis une détection de la dernière valeur maximale.

3. Dispositif selon l'une quelconque des revendications précédentes, dans lequel si la commande détecte que la valeur maximale est inférieure à une valeur seuil générale dans un laps de temps, la commande est configurée pour commander directement le commutateur pour déconnecter une charge.

4. Dispositif selon l'une quelconque des revendications précédentes, dans lequel la valeur seuil de courant des valeurs de courant de charge en relation avec la valeur maximale détectée est comprise entre 25% et 75% de la valeur maximale détectée.

5. Dispositif selon la revendication 4, dans lequel la valeur seuil de courant des valeurs de courant de charge en relation avec la valeur maximale détectée est de 50% de la valeur maximale détectée.

6. Dispositif selon l'une quelconque des revendications précédentes, dans lequel la commande est configurée pour détecter la variation de sorte que deux valeurs de courant de charge subséquentes soient détectées, et les deux valeurs de courant de charge subséquentes sont comparées l'une à l'autre; et
dans lequel la variation dépasse la valeur seuil de variation si la dernière valeur des deux valeurs subséquentes de courant de charge est d'une certaine quantité inférieure à la valeur précédente des deux valeurs subséquentes de courant de charge; et la commande a effectué une détection pendant un temps prédéterminé.

7. Dispositif selon l'une quelconque des revendications 1-5 précédentes, dans lequel la commande est configurée pour détecter la variation de sorte que trois valeurs subséquentes de courant de charge soient détectées, la valeur la plus centrale des trois valeurs subséquentes de courant de charge est supprimée et les valeurs les plus extrêmes des trois valeurs subséquentes de courant de charge sont comparées les unes aux autres; et dans lequel la variation dépasse la valeur seuil de variation si une différence entre les valeurs les plus extrêmes dépasse une certaine quantité; et la commande a effectué une détection pendant un temps prédéterminé.

8. Dispositif selon l'une quelconque des revendications précédentes, dans lequel la commande est configurée pour commander le commutateur pour déconnecter une charge de sorte que le courant de charge soit coupé à partir d'une extrémité basse-tension entre le dispositif et la batterie.

9. Dispositif selon l'une quelconque des revendications précédentes, dans lequel la commande est configurée pour commander le commutateur pour déconnecter une charge de sorte que le courant de charge soit coupé à partir d'une extrémité haute-tension entre l'électricité du secteur et le dispositif.

10. Dispositif selon les revendications 8 ou 9, dans lequel, après avoir commandé le commutateur pour déconnecter une charge, la commande est en outre configurée pour arrêter le dispositif après un laps de temps prédéterminé.

11. Dispositif selon l'une quelconque des revendications précédentes, dans lequel après avoir commandé le commutateur pour déconnecter une charge, la commande est en outre configurée pour allumer l'éclairage du dispositif.

12. Dispositif selon la revendication 1, dans lequel le détecteur est configuré pour détecter la valeur de courant de charge sur la base de mesures de filtrage du courant de charge ayant lieu en une seconde;
stocker les valeurs de courant de charge par seconde;
moyenner les valeurs de courant de charge stockées par minute, dans lequel la valeur moyenne de courant de charge établit ladite valeur de courant de charge.

13. Chargeur (500"), comprenant le dispositif (400) selon l'une quelconque des revendications précédentes, configuré pour charger la batterie du dispositif électrique.

14. Structure (500') comprenant le dispositif (400) selon l'une quelconque des revendications 1-12 précédentes, configuré pour charger la batterie du dispositif électrique.

15. Procédé, comprenant:
détecter un courant de charge d'une batterie d'un appareil électrique;
déterminer des valeurs de courant de charge du courant de charge;
détecter une valeur maximale des valeurs de courant de charge en relation avec la valeur maximale détectée;
après une détection de la valeur maximale, détecter une valeur seuil de courant des valeurs de courant de charge;
après une détection de la valeur seuil de courant, détecter une variation des valeurs subséquentes des valeurs de courant de charge, et
sur la base de la variation détecter si la variation dépasse une valeur seuil de variation; dans lequel la variation dépasse la valeur seuil de variation si une dernière valeur des valeurs subséquentes est une certaine quantité plus petite qu'une valeur précédente des valeurs subséquentes;
après une détection du dépassement de la valeur seuil de variation, commander le commutateur pour déconnecter une charge.

16. Programme informatique, comprenant un code de programme configuré pour exécuter les étapes du procédé de la revendication 15 lorsqu'il est exécuté par un ordinateur.
